Europäisches Patentamt

European Patent Office

Office européen des brevets

(11) Publication number: **0 451 378 A1**

# EUROPEAN PATENT APPLICATION

(21) Application number: 90303827.1

(22) Date of filing: **10.04.90**

(51) Int. Cl.5: **H03K 17/04**, H03K 5/24, H03F 3/45

(43) Date of publication of application:
**16.10.91 Bulletin 91/42**

(84) Designated Contracting States:
**AT BE CH DE DK ES FR GB GR IT LI LU NL SE**

(71) Applicant: **Hewlett-Packard Limited**
**Nine Mile Ride**
**Wokingham, Berkshire RG11 3LL(GB)**

(72) Inventor: **Pottinger, John Rodney**
**7 Canmore Grove, Dunfermline**
**Fife, Scotland KY12 0JT(GB)**
Inventor: **Rasaratnam, Daya**
**28 Echline Park South Queensferry**
**West Lothian, Scotland EH30 9XQ(GB)**

(74) Representative: **Smith, Norman Ian et al**
**F.J. CLEVELAND & COMPANY 40-43**
**Chancery Lane**
**London WC2A 1JQ(GB)**

(54) FET amplifying circuits and methods of operation.

(57) An amplification circuit is disclosed which comprises a differential stage employing field effect transistors (30, 31). The FET devices are source coupled and the bias voltage on the drain electrodes is arranged to vary according to the magnitude of the current being switched. This has been found to reduce the problem of negative overshoot. Also disclosed is a technique for optimising the operation of an amplification circuit comprising a number of differential stages.

FIG.2

This invention relates to amplifying circuits which make use of differential stages employing field effect transistors. It is known to provide amplifying circuits which make use of one or more differential stages formed from source coupled FET's. A problem with such circuits is the effect of the capacitance at the common source node at high frequencies. This is made up of capacitances at the drain of the current sink or tail FET, the source of the other FET of the pair of transistors and parasitic capacitance to ground. This can adversely affect the symmetry of the output waveform.

A known way of improving the edge speeds of the waveform is to use it to drive a differential stage, such as that referred to above, into limiting. If this driving signal is sufficiently large the stage will be fully switched. The output amplitude can then be accurately varied by varying the current in the tail FET. This mode of operation should produce waveforms with substantially flat tops and bottoms. However, because of the effect of the capacitance referred to above the output waveform has a noticeable negative overshoot which also leads to poor symmetry between rising and falling edges. This overshoot increases in significance as the magnitude of the switched current (and therefore the output amplitude) is reduced, to result in an unacceptable waveform. If the driving signal is increased to further improve the edges speeds at any given output amplitude this also increases the negative overshoot.

The present invention is concerned with ways of reducing the negative overshoot problem.

A first aspect of the present invention provides a differential type amplification circuit comprising a pair of FET devices whose source electrodes are coupled characterised in that the bias voltage on the drain electrodes of the FET devices is arranged to vary according to the magnitude of the current being switched. The circuit may include a tail FET to which a bias signal can be applied. The circuit may include a plurality of said pairs of FET devices.

A second aspect of the invention provides a circuit comprising a plurality of stages at least some of which are made up of differential FET pairs wherein a parameter of the final differential stage is sensed and one or more parameters of the stages are adjusted to set said levels at selected values to optimise the operation of the circuit.

The parameters may be selected such that the output switching stage is overdriven by a defined amount. The parameters which are adjusted may include currents applied to the tails of said stages.

A third aspect of the invention provides a method of operating a differential type amplification circuit which includes a pair of FET devices comprising varying the voltage on the drain electrodes of the FET devices in accordance with the magnitude of current being switched in such a way as to minimise negative overshoot in the output waveform.

A fourth aspect of the invention provides a method of optimising operation of an amplification circuit which comprises a plurality of stages at least some of which are made up of differential FET pairs, the method comprising adjusting selected parameters of at least some of the stages such that the output switching stage is overdriven by a defined amount.

The invention will be described now by way of example only, with particular reference to the accompanying drawings. In the drawings:

Figure 1 is a diagram showing an amplification circuit in accordance with the present invention;

Figure 2 is a circuit diagram showing in more detail two of the stages of Figure 1;

Figure 3 shows a circuit for detecting output signals from the circuit of Figure 1;

Figure 4 is a characteristic diagram illustrating the operation of the circuit of Figure 2;

Figure 5 is a circuit diagram showing a modification of the circuit of Figure 2;

Figure 6 is a circuit diagram showing another modification of the circuit of Figure 2, and

Figures 7 and 8 show waveforms which illustrate the reduction of negative overshoot achieved by circuits in accordance with the present invention.

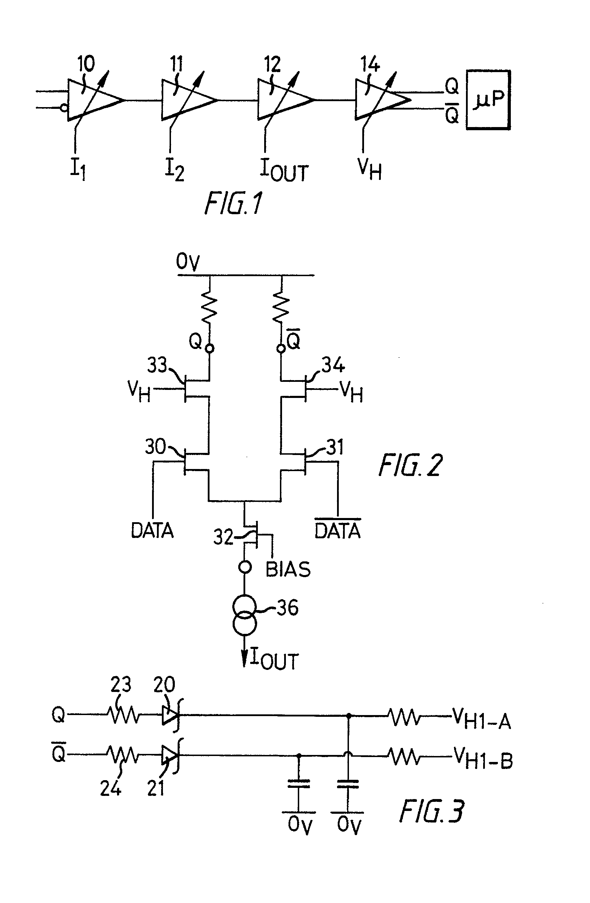

Referring to Figure 1 an amplification circuit comprises four stages 10, 11, 12, and 14. The first three stages 10, 11, and 12 comprise differential switches which are implemented using FET pairs. The stage 14 is a cascode stage. The stage 10 acts as a preamplifier stage, the stage 11 is a driver stage and the stage 12 is an output stage. On Figure 1 $I_1$ represents a current which can be applied to the tail of stage 10, $I_2$ represents a current which can be applied to the tail of the driver stage 11, and $I_{OUT}$ is the output amplitude of the output switch 12. $V_H$ is a voltage signal which can be used to control the drain source voltage of the stage 12. $I_1$, $I_2$ and $V_H$ are parameters which are controlled by a microprocessor in order to optimise the operation of the circuit. In the present arrangement this is achieved by detecting the Q and $\overline{Q}$ levels from the cascode stage 14. It has been found that the negative overshoot of the output waveform can be minimised when the output switch 12 is overdriven by a defined amount. Additionally the stage 11 should also be overdriven by a defined amount.

The Q and $\overline{Q}$ levels from the stage 14 are detected using the circuit shown in Figure 3. This comprises two Schottky diodes 20, 21 which respectively receive the levels via resistors 23, 24.

The ouptut from the circuit is a signal $V_{H1}$ which is fed to a microprocessor. The microprocessor detects the signal $V_{H1}$ and operates to adjust the values of $I_1$, $I_2$, and $V_H$ in accordance with the following algorithm.

1. Set $I_{OUT}$ for the required output amplitude.
2. Adjust $I_1$, $I_2$, and $V_H$ to a maximum.
3. Reduce $I_2$ until $V_{H1}$ just drops. Record $I_2$
4. Reduce $I_1$ until $V_{H1}$ just drops. Record $I_1$
5. Reduce $V_H$ until $V_{H1}$ just drops.
6. For operation, increase $I_1$ and $I_2$ by defined amounts to give an optimum overdrive.

It has been found that in this condition the operation of the circuit of Figure 1 is optimised.

An alternative to step 5 is to measure the output waveform rise and fall times, and record the the value of $V_H$ which gives the best waveform symmetry, as $V_H$ is varied. The value of $V_H$ is stored stored in the instrument. This is repeated for several values.

There are several alternative ways in which the circuit of Figure 1 can be arranged to operate.

One way is to calibrate $I_1$, $I_2$ and $V_H$ for all $I_{OUT}$ settings and store these values in a non-volatile RAM for access by the microprocessor.

An alternative is to calibrate $I_1$, $I_2$ and $V_H$ as each amplitude is set by a user.

A further alternative is to carry out some on-line calibration to take account of, for example, temperature effects. This is possible because $V_{H1}$ needs adjustment by only ~ 10mV to optimise $I_1$, $I_2$ and $V_H$ once the initial values have been set.

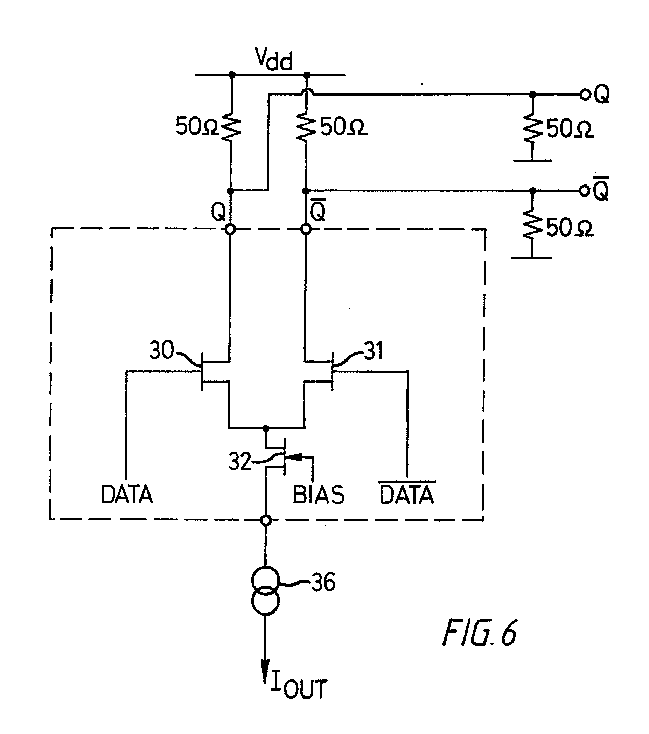

Figure 2 shows in more detail the basic elements of the stage 12. The stage 12 comprises a pair of differential source coupled FET's 30, 31 which receive differential input signals at the respective gates. Bias signals can be applied to each FET by way of a tail FET 32. The FET's 33, 34 make up the cascode stage 14. $V_H$ is applied to the gates of the FET's 33, 34. A current source 36 can be used to alter the amplitude of the output signals. By altering the bias applied to the tail FET's it is possible to select which parts of the differential stage will conduct, (Fig. 5).

In use the FET pair 30, 31 is operated by adjusting the dc bias on the drains of the FET pair according to magnitude of the switched current in such a way as to minimise negative overshoot in the output waveform. This is achieved using the non-linearities in the devices as will now be explained.

Consider the situation with a differential signal being applied to the gates of the two devices 30, 31. For small deviations about the dc bias points operation will be linear and no signal will appear at the common-source node. However, if the applied signal is increased a threshold will be reached when one of the FET's is turned off completely whilst the other provides all the current demanded by the current sink. If the applied signal is further increased in the positive direction, the "on" FET, since there is no further current available to it, will be required to maintain a constant gate to source voltage ($V_{gs}$). As a result the source will track the gate. Unfortunately, with real devices and current source, there will be a finite impedance at the common source node largely due to unwanted capacitances, and the signal modulation of this node will be transferred to the waveform at the drain as a negative overshoot on the falling edge.

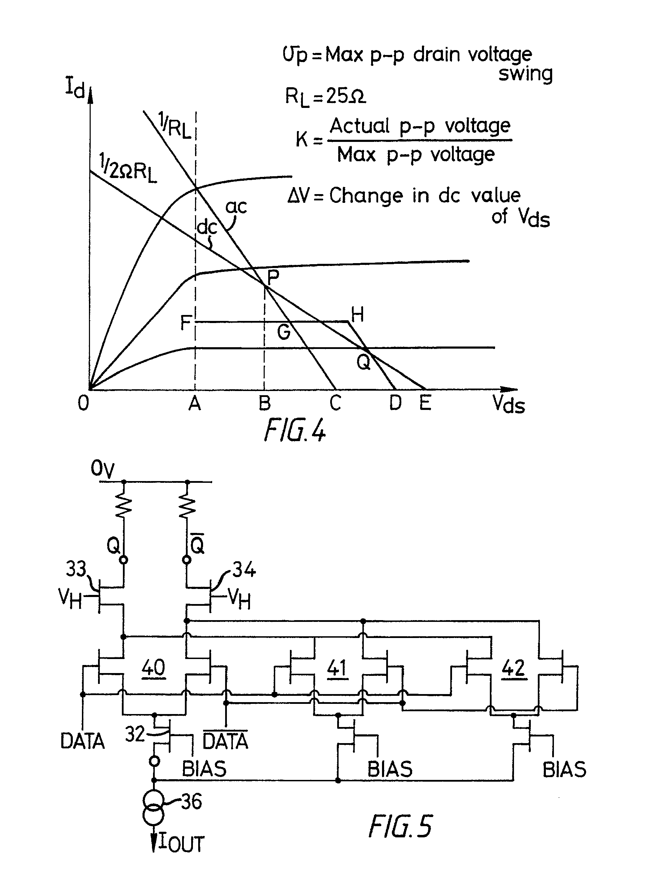

Figure 4 shows the characteristics of a hypothetical FET where the non-saturated to saturated region transitions occur at the same value of drain to source voltage (Vds) for all working values of $V_{gs}$. DC and AC load-lines for one of the FET devices are superimposed on these characteristics.

The operating point P on Figure 4 is set by choosing a value of drain voltage that will result in the whole load-line from C to L being traversed with a given input signal level and maximum value of tail current (or output amplitude). This load-line intersects the saturated to non-saturated and non-saturated to cut-off region boundries at L and C respectively. If the edge speeds of the output waveform are to be faster than that of the input waveform then the magnitude of input signal will have to be more than large enough for traversal of the CL part of the load-line. The FET will therefore be forced into its non-saturated region at the top end of the input waveform. The spacing of the characteristics in the non-saturated region are such that the source will remain largely decoupled from the gate and $V_{gs}$ will continue to increase. This effective decoupling of the source from the gate prevents the excessive negative overshoot on the falling edge of the output waveform. If $V_{gs}$ is allowed to increase until the gate junction becomes forward biased, gate current will flow. This shows up as a distortion to the bottom of the output waveform. However the maximum value of Vgs can be readily limited to prevent this latter situation.

The operating point Q has been chosen at a smaller but arbitrary value of the output amplitude and thus tail current. In this case if the input signal is increased above the level necessary for this device to provide all the demanded tail current, the condition of constant Vgs will be attained and the FH section of the load-line will be traversed with the consequent waveform degradation. However, if Q can be shifted to the left of the device characteristics so that FH is reduced to zero then the source is effectively decoupled from the gate and the waveform degradation is significantly reduced. This shift in the position of Q is attained by reducing the voltage at the drain of the FET. The value of this reduction is a function of the output amplitude or tail current. If the input signal remains at the same level as for maximum output amplitude, however, then FH will require to be large enough to absorb some of this signal in the saturated region to prevent the gate junction from being driven into forward conduction. This would mean that some extra negative overshoot must be tolerated at the output. Alternately, the input signal level can be reduced with output amplitude so that FH and thus negative overshoot is minimised.

Thus it can be seen that reducing drain voltage as a function of output amplitude makes it possible to achieve waveforms with improved symmetry and reduced overshoot.

In this case, it can be shown that the change in drain voltage which must accompany a change in output amplitude so that the same value of $V_{ds}$ is maintained at the positive peak of the waveform as in the maximum amplitude case is

$$1.62 \ (1-k) \ V_{pp}$$

where $k$ = $\dfrac{\text{actual peak to peak voltage}}{\text{maximum peak to peak voltage}}$

and $V_{pp}$ = maximum peak to peak voltage.

With practical FET's the above theoretical expression must be modified to account for realistic I $I_d$ vs $V_{gs}$ characteristics.

Figure 5 shows a modification of the circuit of Figure 2 which employs three pairs 40, 41, 42 of switching FET's. This arrangement allows the tail FET's to control the distribution of the externally generated current. Thus for example, at small values of current all the current is switched by only one FET pair, with a considerable reduction in circuit capacitance and hence negative overshoot. This arrangement further minimises the overshoot problem.

Figure 6 shows a further modification where the supply rail $V_{dd}$ is varied to set up the bias voltage ($V_{ds}$) across the switching FET's. Such an arrangement is used where the output can be ac coupled, because the changes is $V_{dd}$ do not effect the dc level of the output.

It will be appreciated that the stages 10 and 11 are similar to that shown in for example Figure 2, but without the cascode stage 14. These stages operate in a manner similar to that described with reference to Figure 2.

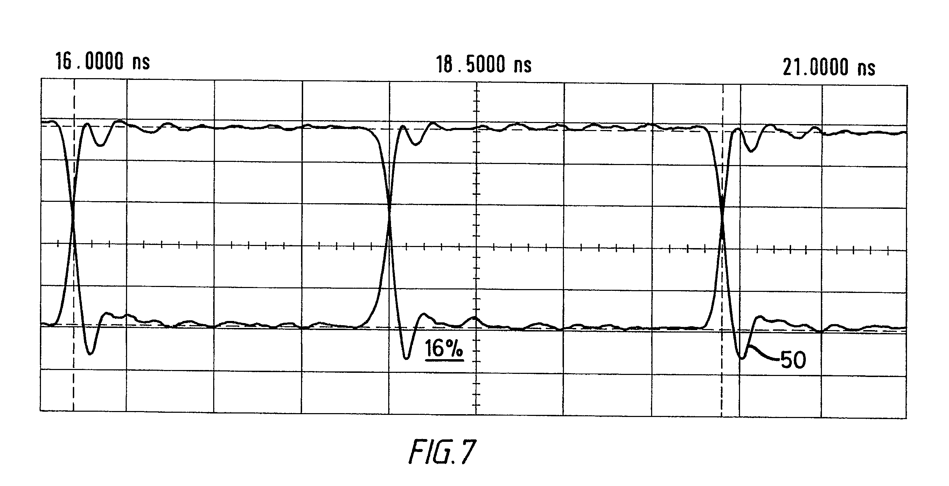

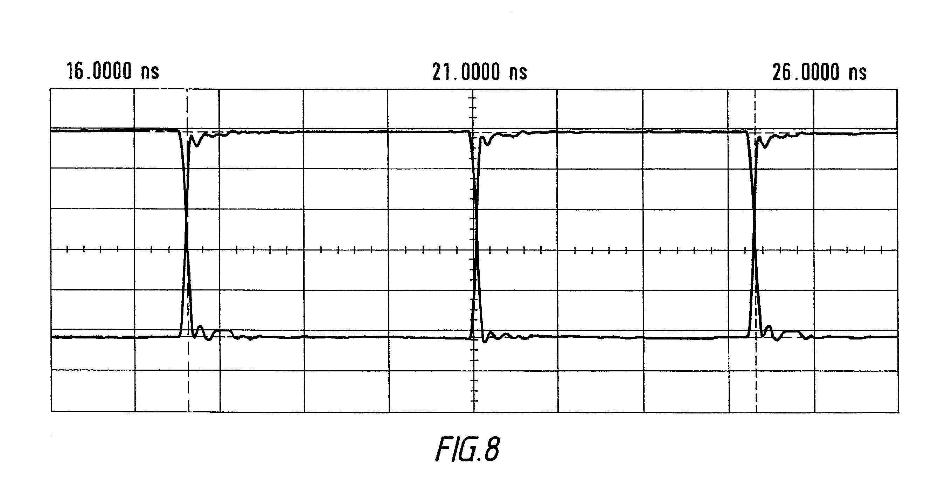

The improvement provided by the present circuit is illustrated in Figure 7 and 8. The waveform of Figure 7 is that produced by a correctional device and has a significant overshoot 50. Figure 8 shows an output waveform of a circuit of the present invention and the overshoot is substantially negligible.

## Claims

1. A differential type amplification circuit comprising a pair of FET devices whose source electrodes are coupled characterised in that the bias voltage on the drain electrodes of the FET devices is arranged to vary according to the magnitude of the current being switched.

2. A differential type amplification circuit according to claim 1, including a tail FET to which a bias signal can be applied.

3. A differential type amplification circuit according to claim 1 or claim 2, and comprising a plurality of said pairs of FET device.

4. A circuit comprising a plurality of stages at least some of which are made up of differential FET pairs wherein the a parameter of the final differential stage is sensed and one or more parameters of the stages are adjusted to set said levels at selected values to optimise the operation of the circuit.

5. A circuit according to claim 4, wherein said parameters are selected such that the output switching stage is overdriven by a defined amount.

6. A circuit according to claim 4 or claim 5, wherein said sensed parameter of the final differential stage is the output level or the measured output switching speed or both.

7. A circuit according to any one of claims 4 to 6, wherein at least some of said stages each comprise a differential type amplification circuit in accordance with any one of claims 1 to 3.

8. A circuit according to any one of claims 4 to 7, wherein the parameters which are adjusted include currents applied to the tails of said stages.

9. A circuit according to any one of claims 4 to 8, including a cascode stage and a circuit for detecting the output levels of the cascode stage.

10. A method of operating a differential type amplification circuit which includes a pair of FET devices comprising varying the voltage on the drain electrodes of the FET devices in accordance with the magnitude of current being switched in such a way as to minimise negative overshoot in the output waveform.

11. A method of optimising operation of an amplification circuit which comprises a plurality of stages at least some of which are made up of differential FET pairs, the method comprising adjusting selected parameters of at least some of the stages such that the output switching stage is overdriven by a defined amount.

12. A method according to claim 11, wherein such parameters include the tail currents of one or more of said stages.

FIG.1

FIG.2

FIG.3

$U_p$ = Max p-p drain voltage swing

$R_L = 25\Omega$

$K = \dfrac{\text{Actual p-p voltage}}{\text{Max p-p voltage}}$

$\Delta V$ = Change in dc value of $V_{ds}$

FIG.4

FIG.5

FIG.6

_16%_

_50_

*FIG.7*

EP 0 451 378 A1

FIG.8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-4 533 877 (CHOWDHURY F. RAHIM) * Figure 1; column 2, line 57 - column 3, line 22 * | 1-3,10 | H 03 K 17/04 H 03 K 5/24 H 03 F 3/45 |
| A | US-A-3 541 465 (MINORU NAGATA) * Figure 3; column 5, lines 23-46 * | 1,9 | |
| A | EP-A-0 139 078 (NEC CORP.) * Figure 2; page 5, lines 1-13 * | 1,4 | |
| A | EP-A-0 275 940 (SIEMENS AG BERLIN UND MÜNCHEN) * Figure 1; column 3, line 2 - column 4, line 49 * | 1,8 | |
| A | IEEE JOURNAL OF SOLID-STATE CIRCUITS, vol. SC-17, no. 3, June 1982, pages 522-528, New York, US; M.G. DEGRAUWE et al.: "Adaptive biasing CMOS amplfifiers" * Abstract * | 1,4 | |
| A | GB-A-2 198 306 (CRYSTAL SEMICONDUCTOR CORP.) * Figure 2A; page 5, line 24 - page 6, line 16 * | 4,8 | TECHNICAL FIELDS SEARCHED (Int. Cl.5) H 03 K H 03 F |
| A | IEEE JOURNAL OF SOLID-STATE CIRCUITS, vol. SC-21, no. 1, February 1986, pages 15-30, IEEE, New York, US; Y. TSIVIDIS et al.: "Continuous-time MOSFET-C filters in VLSI" * Figures 1,10 * | 11 | |

The present search report has been drawn up for all claims

| Place of search | Date of completion of the search | Examiner |
|---|---|---|
| THE HAGUE | 07-12-1990 | WALDORFF U. |

EPO FORM 1503 03.82 (P0401)

ANNEX TO THE EUROPEAN SEARCH REPORT
ON EUROPEAN PATENT APPLICATION NO.

EP 90 30 3827

This annex lists the patent family members relating to the patent documents cited in the above-mentioned European search report.
The members are as contained in the European Patent Office EDP file on 20/12/90
The European Patent Office is in no way liable for these particulars which are merely given for the purpose of information.

| Patent document cited in search report | Publication date | Patent family member(s) | | Publication date |
|---|---|---|---|---|
| US-A- 4533877 | 06-08-85 | JP-A- | 60158708 | 20-08-85 |
| US-A- 3541465 | 17-11-70 | None | | |
| EP-A- 0139078 | 02-05-85 | JP-A,B | 57186812 | 17-11-82 |
| | | JP-A- | 57010462 | 20-01-82 |
| | | EP-A,B | 0045841 | 17-02-82 |
| | | US-A- | 4427903 | 24-01-84 |
| EP-A- 0275940 | 27-07-88 | DE-A- | 3701791 | 04-08-88 |
| | | JP-A- | 63194404 | 11-08-88 |
| | | US-A- | 4843341 | 27-06-89 |
| GB-A- 2198306 | 08-06-88 | DE-A,C | 3736735 | 01-06-88 |
| | | FR-A- | 2606565 | 13-05-88 |
| | | JP-A- | 63139416 | 11-06-88 |

EPO FORM P0459